# NEW EUROPEAN PATENT SPECIFICATION

(11) **EP 1 939 234 B2**
(45) Date of publication and mention of the opposition decision: **11.04.2018**
(45) Mention of the grant of the patent: 09.11.2011
(21) Application number: 06798487.2
(22) Date of filing: 29.09.2006
(51) Int. Cl.: C08F 283/10, C08F 290/14, C08G 59/24, G03F 7/00, G03F 7/027, G03F 7/038, C08G 65/18

(54) **RESIN COMPOSITION FOR OPTICAL THREE-DIMENSIONAL MOLDED OBJECT**
HARZZUSAMMENSETZUNG FÜR OPTISCHEN DREIDIMENSIONALEN FORMKÖRPER
COMPOSITION DE RÉSINE POUR OBJET OPTIQUE MOULÉ TRIDIMENSIONNEL

(30) Priority: 29.09.2005 JP 2005283644
(43) Date of publication of application: 02.07.2008
(73) Proprietor: Cmet Inc., Yokohama-shi, Kanagawa 222-0033 (JP)
(72) Inventor: ITO, Takashi, Yokohama-shi, Kanagawa 222-0033 (JP); HAGIWARA, Tsuneo, Yokohama-shi, Kanagawa 222-0033 (JP)
(74) Representative: Grünecker Patent- und Rechtsanwälte PartG mbB
(86) International application number: PCT/JP2006/319582
(87) International publication number: WO 2007/037434

(56) References cited:
- EP-A1- 0 848 294
- EP-A1- 1 437 624
- WO-A1-03/093901
- WO-A1-2004/033532
- WO-A1-2004/113056
- WO-A1-2004/113396
- JP-A- 10 168 165
- JP-A- 2002 060 463
- JP-A- 2002 256 057
- JP-A- 2004 217 934
- US-A1- 2004 142 274
- H. Sasaki:"Curing Properties of Oxetane Derivatives:3-Ethyl-3-hydroxymethyl-oxetane Formulated with Expoxide", RadTech 2003 UV/EB Meeting the Challenge, vol II 15 December 2003 (2003-12-15), pages 651-656, Retrieved from the Internet: URL:hzzp://lejradt.vm139.remotion.nl/files_ content/july%202004%20papers/sasakipaperjul y2004.pdf

## Description

### Technical Field

The present invention relates to a resin composition for stereolithography, which is low in absorption of water and moisture even when preserved for a long time in an uncured state, which is capable of maintaining high curing sensitivity (actinic radiation-sensitivity) for a long time, and which is capable of optically fabricating a three-dimensional object in a shortened fabricating time, smoothly and in high productivity by irradiation with actinic radiation, the three-dimensional object being excellent in fabricating accuracy, dimensional accuracy, water resistance, moisture resistance, and mechanical characteristics.

### Background Art

In recent years, a stereolithography of a liquid photo-curable resin composition on the basis of data input in a three-dimensional CAD is widely adopted for the reason that intended three-dimensional object can be fabricated with good dimensional accuracy without making a metal mold.

As an illustrative method of the stereolithography, there can be exemplified a method of: selectively irradiating a liquid surface of a liquid photo-curable resin composition put in a container with computer-controlled ultraviolet laser so as to cure a prescribed thickness with a desired pattern; then supplying a liquid resin composition for one layer on the cured layer and irradiating the resin composition with ultraviolet laser to curing it similarly to the above; and repeating the accumulating operation for obtaining continuous cured layers to finally obtain a three-dimensional object. This stereolithography makes it possible to easily and in a relatively short time obtain a fabricated object having a considerably complicated form.

Various characteristics are required for a resin or resin composition for stereolithography. For example, a high curing sensitivity to actinic radiation, a low viscosity and excellent handling ability in fabricating, a low absorption of water and moisture and less reduction of curing sensitivity after aging, a high resolution of a fabricated object and an excellent fabricating accuracy, a small volume shrinkage in curing, and excellent mechanical characteristics, water resistance, moisture resistance and heat resistance of an object fabricated by curing, are required.

As resin compositions for stereolithography, photo-curable acrylate resin compositions, photo-curable urethane acrylate resin compositions, photo-curable epoxy resin compositions, photo-curable epoxy acrylate resin compositions, and photo-curable vinyl ether resin compositions have been proposed and used. Of these photo-curable resin compositions, photo-curable epoxy resin compositions are attracting attention in recent years for the reason that a fabricated object excellent in dimensional accuracy can be formed.

However, it is pointed that a reaction progresses by a cation generated upon irradiation to a photo-curable epoxy resin composition so that the reaction speed is slow and fabricating takes a lot of time. Accordingly, for the purpose of increasing the reaction speed, it is proposed to add a polyol compound of a low molecular weight such as ethylene glycol or propylene glycol to a photo-curable epoxy resin composition. Further, for the purpose of shortening of fabricating time by an improvement of reaction speed, a resin composition for stereolithography is proposed (see patent document 1), which is a photo-curable resin composition containing a cationic polymerizable organic compound such as an epoxy compound and a radical polymerizable organic compound, and further containing a polyester polyol compound. However, in both cases, the obtained fabricated products are low in dimensional accuracy and issues on water resistance and moisture resistance remain.

Further, it is proposed to add an oxetane compound to a resin composition for stereolithography containing a cationic polymerizable organic compound, such as an epoxy compound, to improve photo-curing sensitivity and devise to shorten fabricating time (see patent documents 2 and 3).

Resin compositions for stereolithography to which an oxetane compound is added are certainly improved in photo-curing sensitivity due to the addition of the oxetane compound. However, it has been found according to detailed examination by the present inventors that: the resin compositions for stereolithography containing an oxetane compound are high in an absorption rate of water and moisture; its photo-curing sensitivity greatly reduces by largely absorbing water and moisture in a short time when the composition is preserved in a highly humid state so as to worsen the fabricating performance; the characteristics of the obtained fabricated object worsen and the effect of addition of the oxetane compound is lost.
Patent Document 1: JP-B-7-103218
Patent Document 2: JP-A-10-168165
Patent Document 3: JP-A-2004-217934

### Disclosure of the Invention

### Problems that the Invention is to Solve

An object of the present invention is to provide a resin composition for stereolithography, which is high in curing sensitivity to actinic radiation, which is capable of fabricating an object in high productivity in a shortened irradiation time of actinic radiation, and further which is low in an absorption rate of water and moisture and is not accompanied by reduction of curing performance even when preserved in a highly humid state, and which is capable of maintaining high curing sensitivity for a long time.

Another object of the present invention is to provide a resin composition for stereolithography, which is excellent in fabricating accuracy, and which is capable of fabricating a three-dimensional object excellent in dimensional accuracy under high humidity, mechanical characteristics, water resistance, moisture resistance and heat resistance, in addition to the above excellent characteristics.

### Means for Solving the Problems

The present inventors repeated earnest examinations for solving the above problems. As a result, the inventors have found that, in a resin composition for stereolithography containing an epoxy compound, an ethylenic unsaturated compound, a photo initiator for cationic polymerization, a photo initiator for radical polymerization initiator, and an oxetane compound, when a compound mainly comprising a specific alicyclic diglycidyl ether compound is used as the epoxy compound, and further when a monooxetane compound having one oxetane group in the molecule and a polyoxetane compound having two or more oxetane groups in the molecule are used in a specific weight ratio as the oxetane compound, a resin composition for stereolithography can be obtained, which is high in curing sensitivity to actinic radiation, which is capable of fabricating a three-dimensional object in high productivity in a shortened fabricating time, which is low in an absorption rate of water content or moisture and is not accompanied by reduction of curing performance even when the composition is preserved in a highly humid state, and which is capable of maintaining high curing sensitivity for a long time.

The present inventors have further found that the resin composition for stereolithography obtained above is excellent in fabricating accuracy, and a three-dimensional object fabricated with the resin composition for stereolithography is excellent in various characteristics such as dimensional accuracy under high humidity, mechanical characteristics, water resistance, moisture resistance and heat resistance.

The present inventors have also found that the above various characteristics can be further improved by using specific compounds as each of the monooxetane compound and the polyoxetane compound in the above resin composition for stereolithography, and have achieved the present invention on the basis of the knowledge.

That is, the present invention is as follows.

The present invention provides the composition as defined in claim 1.

Also, the invention present is as follows.
(2) The resin composition for stereolithography as described in the above (1), wherein the polyoxetane compound (E2) is a polyoxetane compound represented by formula (II): 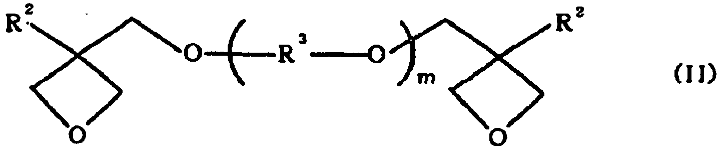 wherein two R^{2,}s, which are the same or different, each represents an alkyl group having 1 to 5 carbon atoms; R³ represents a divalent organic group which has or does not have an aromatic ring; and m represents 0 or 1.
(3) The resin composition for stereolithography as described in the above (1) or (2), wherein the monooxetane compound (E1) is a monooxetane compound represented by formula (III): 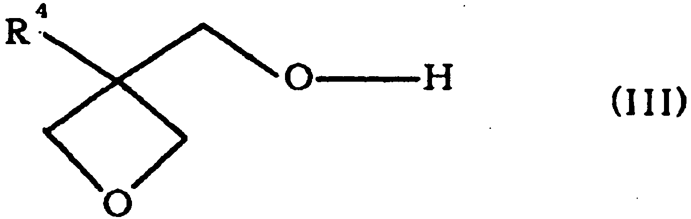 wherein R⁴ represents an alkyl group having 1 to 5 carbon atoms.
(4) The resin composition for stereolithography as described in the above any one of the above (1) to (3), wherein the oxetane compound (E) is included in a proportion of 5 to 60 weight parts with respect to 100 weight parts of the epoxy compound (A).

### Advantage of the Invention

A resin composition for stereolithography in the present invention is high in curing sensitivity to actinic radiation, and an intended three-dimensional object can be fabricated in high productivity in a shortened fabricating time.

A resin composition for stereolithography in the invention is low in an absorption rate of water and moisture and is not accompanied by reduction of curing performance even when the composition is preserved in a highly humid state for a time, which capable of maintaining excellent curing sensitivity for a long time, and which is capable of smoothly fabricating a three-dimensional object excellent in various physical properties including mechanical characteristics even after long term preservation.

A resin composition for stereolithography in the invention is excellent in fabricating accuracy, and a three-dimensional object fabricated with a resin composition for stereolithography in the invention is excellent in characteristics such as dimensional accuracy, mechanical characteristics, water resistance, moisture resistance, heat resistance and the like.

### Best Mode for Carrying Out the Invention

The invention is described in detail below.

An epoxy resin (A) in the invention causes a polymerization reaction and/or a crosslinking reaction when irradiated with actinic radiation in the presence of a photo initiator for cationic polymerization.

The "actinic radiation" in the specification means an energy ray capable of curing a resin composition for stereolithography, such as an ultraviolet ray, an electron beam, an X-ray, a radiant ray and a high frequency wave.

In the invention, as an epoxy resin (A), an epoxy compound containing an alicyclic diglycidyl ether compound (hereinafter, referred to as "alicyclic diglycidyl ether compound (I)") represented by the following formula (I) in the proportion of 20 to 100 weight% based on the total weight of the epoxy compound (A) is used:

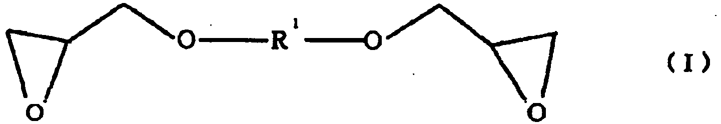

In formula (I), R¹ represents a hydrogenated bisphenol A residue, a hydrogenated bisphenol F residue, a hydrogenated bisphenol Z residue, a cyclohexanedimethanol residue, or a tricyclodecanedimethanol residue

In the invention, by using an epoxy compound having the proportion of the content of the alicyclic diglycidyl ether compound (I) of 20 to 100 weight% as an epoxy compound (A), the curing sensitivity, curing property of a thick layer, resolution, and transmission of ultraviolet ray are further improved. In addition, the viscosity of the resin composition for stereolithography is reduced to smoothly perform fabricating, and the volume shrinkage factor of the obtained object by stereolithography is further reduced.

When the proportion of the content of the alicyclic diglycidyl ether compound (I) is less than 20 weight% based on the total weight of the epoxy compound (A), the dimensional stability of the fabricated object is reduced under a high humidity condition.

As an epoxy resin (A), it is preferred to use an epoxy compound having the proportion of the content of the alicyclic diglycidyl ether compound (I) of 30 to 100 weight%, especially preferably from 50 to 100 weight%, based on the total weight of the epoxy compound (A), thereby not only the moisture resistance of the fabricated object is improved but also dimensional fluctuation by aging becomes small.

As a specific alicyclic diglycidyl ether compounds (I) in the invention, hydrogenated bisphenol A diglycidyl ether, hydrogenated bisphenol F diglycidyl ether, hydrogenated bisphenol Z diglycidyl ether, cyclohexanedimethanol diglycidyl ether, and tricyclodecanedimethanol diglycidyl ether can be exemplified. In the invention, as an alicyclic diglycidyl ether compound (I), the above diglycidyl ethers may be used by one kind alone, or two or more kinds may be used in combination. Of the above exemplified alicyclic diglycidyl ether compounds (I), hydrogenated bisphenol A diglycidyl ether and/or tricyclodecanedimethanol diglycidyl ether are preferably used in the invention from the points of availability and hygroscopic resistance of the fabricated object.

As other epoxy compounds that can be used together with the alicyclic diglycidyl ether compounds (I) as a part of the epoxy compound (A), any epoxy compounds can be used so long as they are capable of cationic polymerization in the presence of a photo initiator for cationic polymerization, and, for example, alicyclic epoxy compounds other than alicyclic diglycidyl ether compounds (I), aliphatic epoxy compounds and aromatic epoxy compounds can be exemplified. As other epoxy compounds, polyepoxy compounds having two or more epoxy groups in the molecule are more preferably used.

As other alicyclic epoxy compounds described above, e.g., polyglycidyl ether of polyhydric alcohol having at least one alicyclic ring, and cyclohexene oxide or cyclopentene oxide-containing compounds obtained by epoxidizing a compound containing cyclohexene or cyclopentene ring with a proper oxidant such as hydrogen peroxide or peracid are exemplified. More specific examples of other alicyclic epoxy resins include, e.g., 3,4-epoxycyclohexylmethyl-3',4'-epoxycyclohexane carboxylate, 2-(3,4-epoxycyclohexyl-5,5-spiro-3,4-epoxy)-cyclohexane-meta-dioxane, bis(3,4-epoxycydohexytmethyl) adipate, vinylcyclohexene dioxide, 4-vinylepoxycyclohexane, bis(3,4-epoxy-6-methylcyclohexylmethyl) adipate, 3,4-epoxy-6-methylcyclohexyl-3,4-epoxy-6-methylcyclohexane carboxylate, methylenebis(3,4-epoxycyclohexane), dicyclo pentadiene diepoxide, di(3,4-epoxycyclohexylmethyl) ether of ethylene glycol, ethylenebis(3,4-epoxycyclohexanecarboxylate), dioctyl epoxyhexahydrophthalate, and di-2-ethylhexyl epoxyhexahydrophthalate.

As the aliphatic epoxy compounds, e.g., polyglycidyl ether of aliphatic polyhydric alcohol or alkylene oxide adducts thereof, and polyglycidyl ester of aliphatic long chain polybasic acid can be exemplified. More specifically, e.g., diglycidyl ether of 1,4-butanediol, diglycidyl ether of 1,6-hexanediol, triglycidyl ether of glycerol, triglycidyl ether of trimethylolpropane, tetraglycidyl ether of sorbitol, hexaglycidyl ether of dipentaerythritol, diglycidyl ether of polyethylene glycol, diglycidyl ether of polypropylene glycol, polyglycidyl ether of polyether polyol obtained by the addition of one or two or more alkylene oxides to aliphatic polyhydric alcohols such as ethylene glycol, propylene glycol, or glycerol, and diglycidyl ester of aliphatic long chain dibasic acid can be exemplified. In addition to the above epoxy compounds, for example, monoglycidyl ether of aliphatic higher alcohol, glycidyl ester of higher fatty acid, epoxidized soybean oil, butyl epoxystearate, octyl epoxystearate, epoxidized linseed oil, and epoxidized polybutadiene can be exemplified.

As the aromatic epoxy compounds described above, mono- or polyglycidyl ether of monohydric or polyhydric phenol having at least one aromatic nucleus or the alkylene oxide adduct thereof can be exemplified. Specifically, e.g., glycidyl ether obtained by the reaction of bisphenol A or bisphenol F, or the alkylene oxide adduct thereof with epichlorohydrin, and monoglycidyl ether of epoxy novolak resin, phenol, cresol, butyl phenol, or polyether alcohols obtained by the addition of alkylene oxide thereto can be exemplified.

In the invention, as the epoxy compounds other than alicyclic diglycidyl ether compound (I), one or two or more of the above epoxy compounds can be used. Of other epoxy compounds described above, bisphenol A diglycidyl ether, ethylene oxide-modified bisphenol A diglycidyl ether, propylene oxide-modified bisphenol A diglycidyl ether, 3,4-epoxycyclohexyl-3',4'-epoxycyclohexanecarboxylate, trimethylolpropanetriglycidyl ether, and glycerol triglycidyl ether are preferably used from the points of reactivity and mechanical characteristics of the cured object.

The ethylenic unsatured compounds (B) compounds used are selected among (meth)acrylic esters of alcohols, polyester(meth)acrylates and polyether(meth)acrylates.

As the (meth)acrylic esters of alcohols that can be used as an ethylenic unsaturated compound (B), (meth)acrylates obtained by the reaction of an aromatic alcohol, aliphatic alcohol, alicyclic alcohol having at least one hydroxyl group in the molecule, and/or the alkylene oxide adduct thereof, with (meth)acrylic acid can be exemplified.

More specifically, for example, 2-ethylhexyl (meth)acrylate, 2-hydroxyethyl (meth)acrylate, 2-hydroxypropyl (meth)acrylate, lauryl (meth)acrylate, stearyl (meth)acrylate, isooctyl (meth)acrylate, tetrahydrofurfuryl (meth)acrylate, isobornyl (meth)acrylate, benzyl (meth)acrylate, 1,4-butanediol di(meth)acrylate, 1,6-hexanediol di(meth)acrylate, diethylene glycol di(meth)acrylate, triethylene glycol di(meth)acrylate, neopentyl glycol di(meth)acrylate, polyethylene glycol di(meth)acrylate, polypropylene glycol di(meth)acrylate, trimethylolpropane tri(meth)acrylate, pentaerythritol tri(meth)acrylate, dipentaerythritol hexa(meth)acrylate, other dipentaerythritol poly(meth)acrylates, (meth)acrylates of the alkylene oxide adducts of the above-described polyhydric alcohols such as diol, triol, tetraol, hexaol, etc., ethylene oxide-modified bisphenol A diacrylate, propylene oxide- modified bisphenol A diacrylate, etc., can be exemplified.

Of these compounds, as the (meth)acrylates of alcohols, (meth)acrylates having two or more (meth)acrylic groups in one molecule obtained by the reaction of polyhydric alcohol and (meth)acrylic acid, e.g., dipentaerythritol poly(meth)- acrylate, are preferably used.

Further, of the above (meth)acrylate compounds, acrylate compounds are preferred to methacrylate compounds in view of polymerization speed.

Further, as the polyester (meth)acrylates that can be used as an ethylenic unsaturated compound (B), polyester (meth)acrylates obtained by the reaction of polyester containing a hydroxyl group and (meth)acrylic acid can be exemplified.

In addition, as the polyether (meth)acrylates, polyether acrylates obtained by the reaction of polyether containing a hydroxyl group and acrylic acid can be exemplified.

Of the above ethylenic unsatured compounds, as an ethylenic unsatured compound (B), isobornyl acrylate, lauryl acrylate, isostearyl acrylate, dipentaerythritol hexaacrylate, dipentaerythritol pentaacrylate, ethylene oxide-modified pentaerythritol tetraacrylate, and ethylene oxide-modified trimethylol- propane triacrylate are preferably used in the invention in view of reactivity and mechanical characteristics of the cured object.

In the invention, as a photo initiator for cationic polymerization (C) (hereinafter sometimes referred to as merely "cationic polymerization initiator (C)"), any polymerization initiators capable of initiating cationic polymerization of the epoxy compound (A) by irradiation with actinic radiation. Of the polymerization "initiators, as cationic polymerization initiator (C), onium salts capable of releasing Lewis acid by irradiation with actinic radiation are preferably used. As the examples of the onium salts, aromatic sulfonium salts of the elements belonging to the group VIIa, aromatic onium salts of the elements belonging to the group VIa, and aromatic onium salts of the elements belonging to the group Va can be exemplified. Specifically, triarylsulfonium hexafluoroantimonate, triphenylphenacylphosphonium tetrafluoroborate, triphenylsulfonium hexafluoroantimonate, bis[4-(diphenylsulfonio)phenyl]sulfide bisdihexafluoroantimonate, bis[4-(di-4'-hydroxyethoxyphenylsulfonio)-phenyl]sulfide bisdihexafluoroantimonate, bis[4-(diphenyl-sulfonio)phenyl]sulfide bisdihexafluorophosphate, and diphenyliodonium tetrafluoroborate can be exemplified.

In the invention, one or two or more of these cationic polymerization initiators can be used. Of the cationic polymerization initiators, aromatic sulfonium salts are more preferably used.

With the object of increasing reaction speed, if necessary, photosensitizers, e.g., benzophenone, benzoin alkyl ether, thioxanthone, etc., may be used together with a cationic polymerization initiator.

As a photo initiator for radical polymerization (D) (hereinafter sometimes referred to as merely "radical polymerization initiator (D)"), any polymerization initiators capable of initiating radical polymerization of ethylenic unsaturated compound (B) by irradiation with actinic radiation can be used. As the examples thereof, benzyl or dialkylacetal compounds thereof, a phenyl ketone compound, an acetophenone compound, benzoin or alkyl ether compounds thereof, a benzophenone compound, a thioxanthone compound, etc., can be exemplified.

Specifically, as the benzyl or dialkylacetal compounds thereof, e.g., benzyl dimethylketal, benzyl-β-methoxyethyl- acetal, etc., are exemplified.

As the phenyl ketone compounds, e.g., 1-hydroxy-cyclohexyl phenyl ketone can be exemplified.

As the acetophenone compounds, e.g., diethoxy-acetophenone, 2-hydroxymethyl-1-phenylpropan-1-one, 4'-isopropyl-2-hydroxy-2-methylpropiophenone, 2-hydroxy- 2-methylpropiophenone, p-dimethylaminoacetophenone, p-tert-butyldichloroacetophenone, p-tert-butyltrichloroaceto- phenone, p-azidobenzalacetophenone, etc., can be exemplified.

As the benzoin compounds, e.g., benzoin, benzoin methyl ether, benzoin ethyl ether, benzoin isopropyl ether, benzoin n-butyl ether, benzoin isobutyl ether, etc., can be exemplified.

As the benzophenone compounds, e.g., benzophenone, methyl o-benzoylbenzoate, Michler's ketone, 4,4'-bisdiethyl- aminobenzophenone, 4,4'-dichlorobenzophenone, etc., can be exemplified.

As the thioxanthone compounds, e.g., thioxanthone, 2-methylthioxanthone, 2-ethylthioxanthone, 2-chlorothio-xanthone, 2-isopropylthioxanthone, etc., can be exemplified.

In the invention, one or two or more radical polymerization initiators (D) can be blended according to desired performances.

As radical polymerization initiator (D), 1-hydroxy-cyclohexyl phenyl ketone is preferably used in the invention for the reason that the hue of the obtained cured product object is good (the degree of yellow is small).

The resin composition for optical stereolithography in the invention contains an oxetane compound (E) together with the epoxy compound (A), ethylenic unsaturated compound (B), cationic polymerization initiator (C) and radical polymerization initiator (D).

In the invention, as an oxetane compound (E), it is necessary to use a monooxetane compound (E1) having one oxetane group in the molecule and a polyoxetane compound (E2) having two or more oxetane groups in the molecule in the weight ratio of monooxetane compound (E1): polyoxetane compound (E2) of 95:5 to 5:95.

Due to this, the absorption rate of water and moisture of the resin composition for stereolithography becomes extremely low, so that the absorption of water content or moisture is low even when the composition is preserved in a highly humid state for a long time, and it is possible to maintain the original high curing sensitivity for a long time.

When the proportion of the monooxetane compound (E1) based on the weight of the oxetane compound (E) deviates from the range of the invention and exceeds 95 weight%

(when the proportion of the polyoxetane compound (E2) is less than 5 weight%), the moisture resistance of the resin composition for stereolithography is reduced, and when the proportion of the monooxetane compound (E1) is less than 5 weight% (when the proportion of the polyoxetane compound (E2) exceeds 95 weight%), the mechanical characteristics of the cured object is reduced, so that in any case the absorption rate of water and moisture becomes low, and a resin composition for stereolithography capable of fabricating a three-dimensional object excellent in mechanical characteristics cannot be obtained.

The weight ratio of the monooxetane compound (E1): the polyoxetane compound (E2) in the oxetane compound (E) is preferably from 10:90 to 90:10, and more preferably from 20:80 to 80:20.

As a monooxetane compound (E1), any compounds can be used so long as they have one oxetane group in one molecule, but monooxetane monoalcohol compounds having one oxetane group and one alcoholic hydroxyl group in one molecule are preferably used.

Of such monooxetane monoalcohol compounds, a monooxetane monoalcohol compound represented by the following formula (III) (hereinafter sometimes referred to as "monooxetane alcohol (III)") is more preferably used as a monooxetane compound (E1) for the reasons of easy availability, high reactivity and low viscosity. 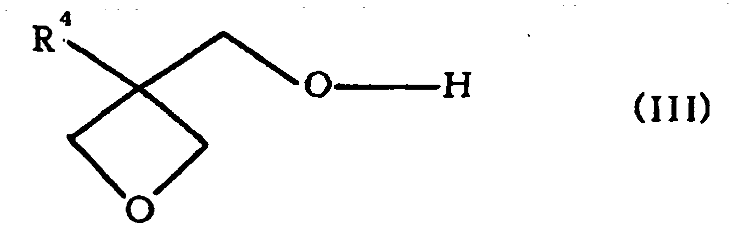 wherein R⁴ represents an alkyl group having 1 to 5 carbon atoms.

In formula (III), as the examples of R⁴, methyl, ethyl, propyl, butyl and pentyl can be exemplified.

As the specific examples of monooxetane alcohol (III), 3-hydroxymethyl-3-methyloxetane, 3-hydroxymethyl-3-ethyloxetane, 3-hydroxymethyl-3-propyloxetane, 3-hydroxy-methyl-3-n-butyloxetane, 3-hydroxymethyl-3-propyloxetane, etc., can be exemplified. These compounds can be used by one kind alone, or two or more kinds can be used. Of these compounds, 3-hydroxymethyl-3-methyloxetane and 3-hydroxymethyl-3- ethyloxetane are more preferably used for easiness of availability and reactivity.

As a polyoxetane compound (E2), any of compounds having two oxetane groups, compounds having three oxetane groups, and compounds having four oxetane groups can be used, but compounds having two oxetane groups are preferably used.

Of these, a dioxetane compound represented by the following formula (II) (hereinafter sometimes referred to as "dioxetane compound (II)") is preferably used as polyoxetane compound (E2) in view of availability, reactivity, low hygroscopicity, and mechanical characteristics of the cured object:

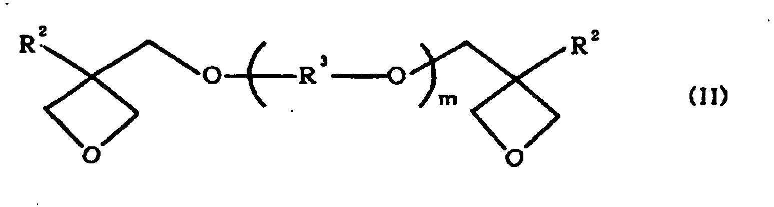

In formula (II), two R²·s, which may be the same or different, each represents an alkyl group having 1 to 5 carbon atoms; R³ represents a divalent organic group having or not having an aromatic ring; and m represents 0 or 1.

In formula (II), as the examples of R², methyl, ethyl, propyl, butyl and pentyl can be exemplified. As the examples of R³, a straight chain or branched alkylene group having 1 to 12 carbon atoms (e.g., an ethylene group, a propylene group, a butylene group, a neopentylene group, an n-pentamethylene group, an n-hexamethylene group, etc.), a divalent group represented by the formula -CH₂-Ph-CH₂- or -CH₂-Ph-Ph-CH₂-, a hydrogenated bisphenol A residue, a hydrogenated bisphenol F residue, a hydrogenated bisphenol Z residue, a cyclohexane-dimethanol residue, a tricyclodecanedimethanol residue, etc., can be exemplified.

As the specific example of dioxetane compound (II), a dioxetane compound represented by the following formula (IIa) or (IIb) can be exemplified.

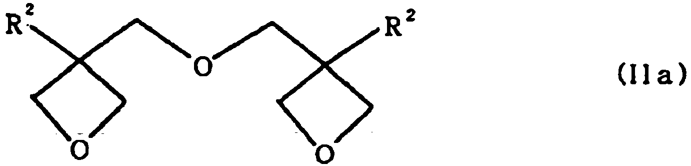

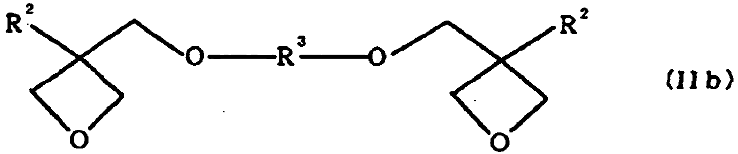

In the formulae, two R²s, which may be the same or different, each represents an alkyl group having 1 to 5 carbon atoms; and R³ represents a divalent organic group having or not having an aromatic ring.

The specific examples of the dioxetane compounds represented by formula (IIa) include bis(3-methyl-3-oxetanylmethyl) ether, bis(3-ethyl-3-oxetanylmethyl) ether, bis(3-propyl-3-oxetanylmethyl) ether, bis(3-butyl-3- oxetanylmethyl)ether, etc.

As the specific examples of the dioxetane compounds represented by formula (IIb), dioxetane compound represented by formula (IIb) wherein two R²·s both represent a methyl, ethyl, propyl, butyl or pentyl group, and R³ represents an ethylene group, a propylene group, a butylene group, a neopentylene group, an n-pentamethylene group, an n-hexamethylene group, etc.), a divalent group represented by the formula -CH₂-Ph-CH₂- or -CH₂-Ph-Ph-CH₂-, a hydrogenated bisphenol A residue, a hydrogenated bisphenol F residue, a hydrogenated bisphenol Z residue, a cyclohexanedimethanol residue or a tricyclodecane-dimethanol residue can be exemplified.

Of these compounds, as polyoxetane compound (E2), dioxetane compounds represented by formula (IIa) wherein two R²s both represent a methyl group or an ethyl group, that is, bis(3-methyl-3-oxetanylmethyl) ether and/or bis(3-ethyl-3-oxetanylmethyl) ether are preferably used from the points of easy availability, low hygroscopicity, and mechanical characteristics of the cured object. In particular, bis(3-ethyl-3-oxetanylmethyl) ether is more preferably used.

In view of the viscosity of the composition, reaction speed, fabricating speed, the dimensional accuracy and mechanical characteristics of the fabricated product, it is preferred for the resin composition for stereolithography in the invention to contain the epoxy compound (A) in the proportion of from 10 to 80 weight% based on the total weight of the resin composition for stereolithography, especially preferably from 15 to 75 weight%, and the ethylenic unsaturated compound (B) in the proportion of 2 to 60 weight%, especially preferably from 5 to 50 weight%.

Further, it is preferred for the resin composition for stereolithography in the invention to contain the cationic polymerization initiator (C) in the proportion of 0.1 to 10 weight% based on the total weight of the composition, especially preferably 0.5 to 10 weight%, and the radical polymerization initiator (D) in the proportion of 0.1 to 10 weight%, especially preferably 0.5 to 10 weight%.

It is preferred for the resin composition for stereolithography in the invention to contain the oxetane compound (E) in the proportion of 6 to 50 weight%, and still more preferably 10 to 45 welght%, thereby the curing sensitivity of the resin composition for stereolithography increases.

When the content of the oxetane compound (E) is small, the curing sensitivity of the resin composition for stereolithography is reduced and fabricating takes a lot of time, and when the content of oxetane compound (E) is too much, not only the hygroscopicity of the resin composition for stereolithography becomes high but also the mechanical characteristics and heat resistance of the cured object is reduced.

The resin composition for optical molding in the invention may contain, if necessary, an appropriate amount of one or two or more kinds of colorants, e.g., a pigment and a dye, a defoaming agent, a leveling agent, a thickener, a flame retardant, an antioxidant, a filler (crosslinking polymer particles, silica, glass powder, ceramic powder, metal powder, etc.), and a resin for modification, so long as the effect of the invention is not impaired.

In a stereolithography using the resin composition of the invention, any known stereolithographic method and apparatus can be used. As an illustrative stereplithographic method that can be preferably adopted, there can be exemplified a method of: selectively irradiating a liquid resin composition of the invention with actinic radiation so as to obtain a cured layer having a desired pattern; then supplying an uncured liquid resin composition on the cured layer and similarly irradiating the resin composition with actinic radiation, and curing similarly to the above; and repeating the fabricating operation to form a cured layer continuing the cured layers so as to finally obtain an intended three-dimensional object.

As the actinic radiation at that time, ultraviolet rays, electron beams, X-rays, radiant rays and high frequency waves can be exemplified as described above. Of the actinic radiation, ultraviolet rays having wavelengths of 300 to 400 nm are preferably used from economical viewpoint. As the light sources at that time, an ultraviolet laser (e.g., semiconductor excitation solid state laser, Ar laser, He-Cd laser, etc.), a high pressure mercury lamp, a super high pressure mercury lamp, a mercury lamp, a xenon lamp, a halogen lamp, a metal halide lamp, an ultraviolet ray LED (light emitting diode), a fluorescent lamp, etc., can be used.

In forming each cured resin layer having a pattern of prescribed form by irradiating a fabricating surface of a resin composition for stereolithography with actinic radiation, a cured resin layer may be formed according to a point drawing or line drawing method by using actinic radiation focused in a spot like a laser beam. A fabricating method of forming a cured resin layer by areally irradiating a fabricating surface with actinic radiation through an areal imaging mask in which a plurality of micro light shutters such as liquid crystal shutters or digital micro mirror shutters (DMD) are arranged may be adopted.

The resin composition for stereolithography in the invention can be widely used in the field of stereolithography, and as illustrative examples, a model for testing visual design, a model for checking the functionality of parts, a resin mold for manufacturing a casting mold, a base model for manufacturing a metal mold, and a direct mold for a prototype metal mold can be exemplified. In particular, the resin composition for stereolithography in the invention can be effective in manufacturing models for precision parts. More specifically, the resin composition for stereolithography in the invention can be effectively used for a model, mother die and model for processing of such as precision parts, electrical and electronic components, furniture, building structures, automobile parts, various kinds of containers and casting mold.

### Examples

The invention will be described specifically with reference to examples, but the invention is by no means restricted thereto. In the examples "parts" means "weight parts" unless otherwise indicated.

In the following examples, the measurement of water content of a resin composition for stereolithography, evaluation of curing performance, measurement of mechanical characteristics of an object fabricated by stereolithography (flexural strength, elastic modulus in flexure, tensile strength, elastic modulus in tension, tensile elongation, surface hardness) and measurement of heat deformation temperature were performed as follows.
(1) Water content of a resin composition for stereolithography:
   The water content of a resin composition for stereolithography was measured with "a capacity titration type water content measuring equipment, Model KF-06", manufactured by Mitsubishi Chemical Corporation according to Karl Fischer's method.
(2) Curing performance of a resin composition for stereolithography:
   By using the photo-curable resin compositions obtained in the following examples or comparative examples, optically fabricating was performed according to the methods described in the following examples and comparative examples (in particular, Example 1 and Comparative Example 1). In each of the resin compositions, the curing performance of the one having a sufficient cured film thickness and whose film thickness could be measured with constant pressure calipers was graded "good", the curing performance of the one whose film thickness could be measured with difficulty was graded "somewhat no good", and the one whose cured film was weak and film thickness could not be measured with constant pressure calipers was graded "no good".
(3) Flexural test of an optically fabricated object:
   By using the optically fabricated object in the following Example 1 or Comparative Example 1 (test piece in the form of a bar in conformity with JIS K-7171), flexural strength and elastic modulus in flexure of the test piece were measured in accordance with JIS K-7171.
(4) Tensile test of an optically fabricated object:
   By using the optically fabricated object in the following Example 1 or Comparative Example 1 (test piece in the form of a dumbbell in conformity with JIS K-7113), tensile strength and elastic modulus in tension of the test piece were measured in accordance with JIS K-7113.
(5) Surface hardness of an optically fabricated object:
   By using the optically fabricated object in the following Example 1 or Comparative Example 1 (test piece in the form of a dumbbell in conformity with JIS K-7113), the surface hardness of the test piece was measured with "Asker type D hardness meter", manufactured by Kobunshi Keiki Co. by a durometer method in accordance with JIS K-7253.
(6) Heat deformation temperature of an optically fabricated object:
   By using the optically molded product manufactured in the following Example 1 or Comparative Example 1 (test piece in the form of a bar in conformity with JIS K-7171), the heat deformation temperature of the test piece was measured with "HDT Tester 6M-2", manufactured by Toyo Seiki Seisaku-Sho, Ltd., by applying a load of 1.813 MPa to the test piece conformed to JIS K-7207(A).

### Example 1

(1) A photo-curable resin composition was prepared by thoroughly blending 2 parts of 3,4-epoxycyclohexylmethyl-3',4'-epoxycyclohexane carboxylate, 58 parts of hydrogenated bisphenol A diglycidyl ether, 5 parts of 3-hydroxymethyl-3-ethyloxetane, 15 parts of bis(3-ethyl-3-oxetanylmethyl) ether, 4 parts of triarylsulfonium hexafluoroantimonate as a cationic polymerization initiator ("UVI-6974", manufactured by The Dow Chemical Company), 10 parts of dipentaerythritol polyacrylate ("NK Ester A-9530", manufactured by Shin Nakamura Chemical Co., Ltd.), and 3 parts of 1-hydroxycyclohexyl phenyl ketone ("Irgacure 184", manufactored by Ciba Specialty Chemicals Inc.) (a radical polymerization initiator).
(2) (i) The water content of the photo-curable resin composition obtained in the above (1) measured according to the above method was 1,020 ppm as shown in Table 1 below.

Further, the photo-curable resin composition obtained in the above (1) was preserved in a desiccator conditioned at humidity of 60%. A fixed amount of the photo-curable resin composition was taken out of the container after aging and the water content was measured and, at the same time, optically fabricating was performed with the taken out photo-curable resin composition according to the following method (ii). The curing performance of the photo-curable resin composition at the time of the optically fabricating was evaluated according to the above method and, at the same time, the absorbing property of the obtained optically fabricated object and the curability of the resin were measured or evaluated by the above method. The results of the following various characteristics were measured according to the above methods.

### (ii) Optically Fabricating

Optically fabricating was performed by irradiating perpendicularly to the surface of the photo-curable resin composition obtained in (i) above with a super high speed optical molding system ("SOLIFORM500B", manufactured by Teijin Seiki Co., Ltd.) and "semiconductor excitation solid state laser BL6 type" (output: 1,000 mW, wavelength: 355 nm, manufactured by Spectra Physics) on the condition of irradiation energy of 80 mJ/cm², slice pitch (thickness of accumulating) of 0.10 mm, to manufacture a test piece in the form of a dumbbell in conformity with JIS K-7113 and a test piece in the form of a bar in conformity with JIS K-7171, and its physical properties were measured according to the methods above. The results obtained are shown in Table 1 below.

### Comparative Example 1

(1) A photo-curable resin composition was prepared by thoroughly blending 2 parts of 3,4-epoxycyclohexylmethyl-3',4'-epoxycyclohexane carboxylate, 58 parts of hydrogenated bisphenol A diglycidyl ether, 20 parts of 3-hydroxymethyl-3-ethyloxetane, 4 parts of triarylsulfonium hexafluoroantimonate as a cationic polymerization initiator ("UVI-6974", manufactured by The Dow Chemical Company), 10 parts of dipentaerythritol polyacrylate ("NK Ester A-9530", manufactured by Shin Nakamura Chemical Co., Ltd.), and 3 parts of 1-hydroxycyclohexyl phenyl ketone ("Irgacure 184", manufactored by Ciba Specialty Chemicals Inc.) (a radical polymerization initiator).
(2) The water content of the photo-curable resin composition obtained in the above (1) measured according to the above method was 980 ppm as shown in Table 1 below.

Further, the photo-curable resin composition obtained in the above (1) was preserved in a desiccator conditioned at humidity of 60%. A fixed amount of the photo-curable resin composition was taken out of the container after aging and the water content was measured and, at the same time, optical three-dimensional molding was performed with the taken out photo-curable resin composition according to the same method as the method (ii) of (2) in Example 1. The curing performance of the photo-curable resin composition at the time of optical three-dimensional molding was evaluated according to the above method, and the absorbing property of the obtained optically molded product and the curability of the resin were measured or evaluated by the above method. The results obtained are shown in Table 1 below.

**Table 1**

| | | Just after Fabricating | After 1 Day | After 4 Days | After 6 Days | After 8 Days | After 12 Days | After 20 Days |
|---|---|---|---|---|---|---|---|---|
| | [Resin Composition] Water content (ppm) | 1,020 | 2,010 | 4,180 | 6,000 | 6,980 | 8,010 | 8,020 |
| | Curing performance | Good | Good | Good | Good | Good | Good | Good |
| | [Optically Fabricated Object] Flexural strength (MPa) | 60 | | 59 | 58 | | 60 | 65 |
| | Elastic modulus in flexure (MPa) | 1,715 | | 1,650 | 1,680 | | 1,740 | 1,800 |
| Ex. 1 | Tensile strength (MPa) | 43 | Not measured | 46 | 43 | Not measured | 43 | 44 |
| | Elastic modulus in tension (Pa) | 1,590 | | 1,670 | 1,620 | | 1,640 | 1,650 |
| | Tensile elongation (%) | 6.3 | | 6.3 | 6.3 | | 6.1 | 6.0 |
| | Surface hardness (Shore D) | 82 | | 82 | 82 | | 82 | 82 |
| | Heat deformation temperature (°C) | 50 | | 49 | 48.5 | | 49 | 49 |
| | [Resin Composition] Water content (ppm) | 980 | 3,950 | 7,980 | 10,100 | 12,020 | 14,100 | 16,000 |
| | Curing performance | Good | Good | Somewhat no good | No good | No good | No good | No good |
| | [Optically Fabricated Object] Flexural strength (MPa) | 64 | | 52 | 43 | | 32 | 28 |
| | Elastic modulus in flexure (MPa) | 1,800 | | 1,400 | 1,230 | | 1,060 | 920 |
| Comp. Ex. 1 | Tensile strength (MPa) | 44 | Not measured | 38 | 36 | Not measured | 32 | 27 |
| | Elastic modulus in tension (Pa) | 1,650 | | 1,380 | 1,250 | | 1,010 | 890 |
| | Tensile elongation (%) | 6.4 | | 8.5 | 9.8 | | 11.2 | 15.2 |
| | Surface hardness (Shore D) | 82 | | 80 | 80 | | 79 | 77 |
| | Heat deformation temperature (°C) | 48.5 | | 45 | 43 | | 40 | 38 |

As can be seen from the results in Table 1, the photo-curable resin composition (the resin composition for stereolithography) in Example 1 is low in absorption of water and can well maintain curing performance for a long time even after being allowed to stand, so that good tensile strength and mechanical characteristics can be obtained even when optically fabricating is performed by irradiation with light after 20 days.

To the contrary, the water content of the photo-curable resin composition (the resin composition for optical three- dimensional molding) in Comparative Example 1 is as high as about 8,000 ppm after 4 days, so that the resin composition is high in an absorption rate of water, and curing performance is reduced in early stage, and in addition, the mechanical characteristics of the obtained three-dimensionally molded product is low.

### Example 2

(1) A photo-curable resin composition was prepared by thoroughly blending 20 parts of 3,4-epoxycyclohexylmethyl-3',4'-epoxycyclohexane carboxylate, 40 parts of hydrogenated bisphenol A diglycidyl ether, 10 parts of 3-hydroxymethyl-3-ethyloxetane, 10 parts of bis(3-ethyl-3-oxetanylmethyl) ether, 4 parts of triarylsulfonium hexafluoroantimonate as a cationic polymerization initiator ("UVI-6974", manufactured by The Dow Chemical Company), 10 parts of dipentaerythritol polyacrylate ("NK Ester A-9530", manufactured by Shin Nakamura Chemical Co., Ltd.), and 3 parts of 1-hydroxycyclohexyl phenyl ketone ("Irgacure 184", manufactored by Ciba Specialty Chemicals Inc.) (a radical polymerization initiator).
(2) The water content of the photo-curable resin composition obtained in the above (1) measured according to the above method was 780 ppm.

Further, the photo-curable resin composition obtained in the above (1) was preserved in a desiccator conditioned at humidity of 60% for 14 days. After preservation, a fixed amount of the photo-curable resin composition was taken out of the container, and the water content measured was 7,500 ppm. Optically fabricating was performed with the photo-curable resin composition after preservation for 14 days according to the same method as in (ii) of (2) in Example 1. The curing performance of the photo-curable resin composition at the time of the optically fabricating was evaluated according to the above method. The curing performance was good.

### Comparative Example 2

(1) A photo-curable resin composition was prepared by thoroughly blending 20 parts of 3,4-epoxycyclohexylmethyl-3',4'-epoxycyclohexane carboxylate, 40 parts of hydrogenated bisphenol A diglycidyl ether, 20 parts of 3-hydroxymethyl-3-ethyloxetane, 4 parts of triarylsulfonium hexafluoroantimonate as a cationic polymerization initiator ("UVI-6974", manufactured by The Dow Chemical Company), 10 parts of dipentaerythritol polyacrylate ("NK Ester A-9530", manufactured by Shin Nakamura Chemical Co., Ltd.), and 3 parts of 1-hydroxycyclohexyl phenyl ketone ("Irgacure 184", manufactored by Ciba Specialty Chemicals Inc.) (a radical polymerization initiator).
(2) The water content of the photo-curable resin composition obtained in the above (1) measured according to the above method was 820 ppm. Further, the photo-curable resin composition obtained in the above (1) was preserved in a desiccator conditioned at humidity of 60% for 14 days. After preservation, a fixed amount of the photo-curable resin composition was taken out of the container, and the water content measured was as high as 13,500 ppm. Optically fabricating was performed with the photo-curable resin composition after preservation for 14 days according to the same method as in (ii) of (2) in Example 1. The curing performance of the photo-curable resin composition at the time of the optically fabricating was evaluated according to the above method. The curing performance was inferior, and only a weak cured film could be obtained.

### Examples 3 to 6

(1) Each of photo-curable resin compositions was prepared by thoroughly blending 2 parts of 3,4-epoxycyclohexylmethyl-3',4'-epoxycyclohexane carboxylate, 58 parts of the alicyclic diglycidyl ether compound shown in Table 2 below, 5 parts of 3-hydroxymethyl-3-ethyloxetane, 15 parts of bis(3-ethyl-3-oxetanylmethyl) ether, 3 parts of triarylsulfonium hexafluoroantimonate as a cationic polymerization initiator ("UVI-6974", manufactured by The Dow Chemical Company), 15 parts of dipentaerythritol polyacrylate ("NK Ester A-9530", manufactured by Shin Nakamura Chemical Co., Ltd.), and 3 parts of 1-hydroxycyclohexyl phenyl ketone ("Irgacure 184", manufactored by Ciba Specialty Chemicals Inc.) (a radical polymerization initiator).
(2) Each of the photo-curable resin compositions obtained in the above (1) was preserved in a desiccator conditioned at humidity of 60% for 14 days. After preservation, a fixed amount of the photo-curable resin composition was taken out of the container, and the water content was measured. The result of measurement of each resin composition is shown in Table 2 below. Optically fabricating was performed with the photo-curable resin composition after preservation for 14 days according to the same method as in (ii) of (2) in Example 1. The curing performance of each photo-curable resin composition at the time of the optically fabricating was evaluated according to the above method. The curing performance was good with every resin composition as shown in Table 2 below.

**Table 2**

| | Example 3 | Example 4 | Example 5 | Example 6 |
|---|---|---|---|---|
| Kind of alicyclic diglycidyl ether compound | Hydrogenated bisphenol F diglycidyl ether | Hydrogenated bisphenol Z diglycidyl ether | Tricyclodecanedimethylol diglycidyl ether | Rika Resin DME-100¹⁾ |
| Water content (ppm) (after 14 days) | 8,210 | 6,870 | 7,200 | 8,200 |
| Curing performance (after 14 days) | Good | Good | Good | Good |
| 1) RIKARESIN DME-100: | | | | |

### Examples 7 to 12

(1) Each of photo-curable resin compositions was prepared by thoroughly blending 10 parts of 3,4-epoxycyclohexylmethyl-3',4'-epoxycyclohexane carboxylate, 50 parts of hydrogenated bisphenol A diglycidyl ether, 5 parts of 3-hydroxymethyl-3-ethyloxetane, 15 parts of the dioxetane compound shown in Table 3 below, 3 parts of triarylsulfonium hexafluoroantimonate as a cationic polymerization initiator ("UVI-6974", manufactured by The Dow Chemical Company), 15 parts of dipentaerythritol polyacrylate ("NK Ester A-9530", manufactured by Shin Nakamura Chemical Co., Ltd.), and 3 parts of 1-hydroxycyclohexyl phenyl ketone ("Irgacure 184", manufactored by Ciba Specialty Chemicals Inc.) (a radical polymerization initiator).
(2) Each of the photo-curable resin compositions obtained in the above (1) was preserved in a desiccator conditioned at humidity of 60% for 14 days. After preservation, a fixed amount of the photo-curable resin composition was taken out of the container, and the water content was measured. The result of measurement of each resin composition is shown in Table 3 below. Optically fabricating was performed with the photo-curable resin composition after preservation for 14 days according to the same method as in (ii) of (2) in Example 1. The curing performance of the photo-curable resin composition at the time of the optically fabricating was evaluated according to the above method. The curing performance was good with every resin composition as shown in Table 3 below.

Dioxetane compounds (IIc₁) to (IIc₆) used in Examples 7 to 12 are dioxetane compounds represented by the following formula (IIc): 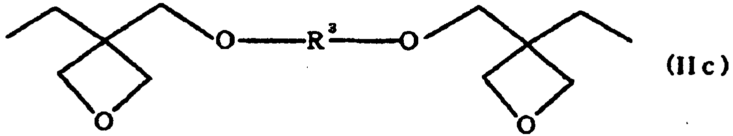
(IIc₁) is a dioxetane compound, wherein R³ represents a neopentylene group;
(IIc₂) is a dioxetane compound, wherein R³ represents an n-pentamethylene group;
(IIc₃) is a dioxetane compound, wherein R³ represents an n-hexamethylene group; (IIc₄) is a dioxetane compound, wherein R³ represents a 1,4-xylylene group; (IIc₅) is a dioxetane compound, wherein R³ represents a cyclohexane-1,4-dimethylene group; (IIc₆) is a dioxetane compound, wherein R³ represents a hydrogenated bisphenol-4,4'-dimethylene group.

**Table 3**

| | Example 7 | Example 8 | Example 9 | Example 10 | Example 11 | Example 12 |
|---|---|---|---|---|---|---|
| Kind of dioxetane compound (IIc)¹⁾ | (IIc₁) | (IIc₂) | (IIc₃) | (IIc₄) | (IIc₅) | (IIc₆) |
| Water content (ppm) (after 14 days) | 6,300 | 6,100 | 5,900 | 4,800 | 5,300 | 3,950 |
| Curing performance (after 14 days) | Good | Good | Good | Good | Good | Good |
| 1) The kinds *of* dioxetane *compounds* (IIc): | | | | | | |
| (IIc₁) is a dioxetane compound represented by formula (IIc) wherein R³ represents a neopentylene group; | | | | | | |
| (IIc₂) is a dioxetane compound represented by formula (IIc) wherein R³ represents an n-pentamethylene group; | | | | | | |
| (IIc₃) is a dioxetane compound represented by formula (IIc) wherein R³ represents an n-hexamethylene group; | | | | | | |
| (IIc₄) is a dioxetane compound represented by formula (IIc) wherein R³ represents a 1,4-xylylene group; | | | | | | |
| (IIc₅) is a dioxetane compound represented by formula (IIc) wherein R³ represents a cydohexane-1,4-dimethylene group; | | | | | | |
| (IIc₆) is a dioxetane compound represented by formula (IIc) wherein R³ represents a hydrogenated bisphenol-4,4'-dimethylene group. | | | | | | |

### Industrial Applicability

A resin composition for stereolithography in the invention is low in absorption of water and moisture even when the composition is preserved for a long time inan uncured state, is capable of maintaining high curing sensitivity (sensitivity to actinic radiation) for long time, and is capable of optically fabricating a three-dimensional object in a shortened molding time, smoothly and in high productivity when fabricated by irradiation with actinic radiation, the three-dimensional object being excellent in fabricating accuracy, dimensional accuracy, water resistance, moisture resistance, and mechanical characteristics. Therefore, a model or model for processing of precision parts, electrical and electronic components, furniture, building structures, automobile parts, various kinds of containers, casting molds, metal molds and mother dies; parts for design of complicated heat medium circuits, parts for analysis and planning of behavior of heat medium having complicated structures; and other various kinds of three-dimensional molded objects having complicated forms and structures can be obtained with high fabricating speed, high dimensional accuracy and smoothly by using a resin composition for stereolithography in the invention.

## Claims

1. A resin composition for stereolithography, (i) comprising:
an epoxy compound (A);
an ethylenic unsaturated compound (B);
a photo initiator for cationic polymerization (C);
a photo initiator for radical polymerization (D); and
an oxetane compound (E),
(ii) wherein an epoxy compound containing an alicyclic diglycidyl ether compound is included as the epoxy compound (A) in a proportion of 20 to 100 weight% with respect to a total weight of the epoxy compound (A), the alicyclic diglycidyl ether compound being represented by formula (I): 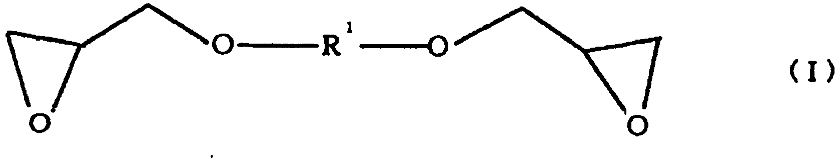 wherein R¹ represents a hydrogenated bisphenol A residue, a hydrogenated bisphenol F residue, a hydrogenated bisphenol Z residue, a cyclohexanedimethanol residue, or a tricyclodecanedimethanol residue, and
(iii) wherein an oxetane compound containing: a monooxetane compound (E1) having one oxetane group in a molecule thereof; and a polyoxetane compound (E2) having two or more oxetane groups in a molecule thereof is included as the oxetane compound (E) in a weight ratio of the monooxetane compound (E1) to the polyoxetane compound (E2) of 95:5 to 5:95, wherein the oxetane compound (E) is included in a proportion of 5 to 60 weight parts with respect to 100 weight parts of the epoxy compound (A),
wherein the ethylenic unsatured compounds (B) compounds are selected among (meth)acrylic esters of alcohols, polyester(meth)acrylates and polyether(meth)acrylates.

2. The resin composition for stereolithography according to claim 1, wherein the polyoxetane compound (E2) is a polyoxetane compound represented by formula (II): 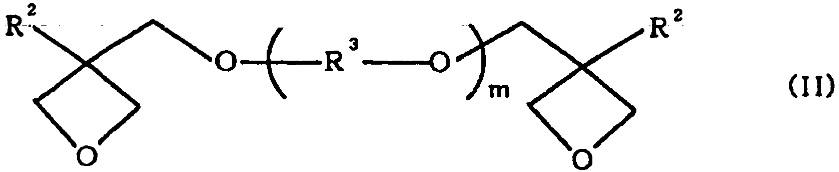 wherein two R^{2'}s, which are the same or different, each represents an alkyl group having 1 to 5 carbon atoms; R³ represents a divalent organic group which has or does not have an aromatic ring; and m represents 0 or 1.

3. The resin composition for stereolithography according to claim 1 or 2, wherein the monooxetane compound (E1) is a monooxetane compound represented by formula (III): 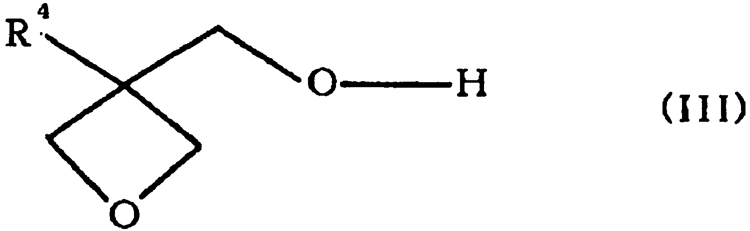 wherein R⁴ represents an alkyl group having 1 to 5 carbon atoms.

## Patentansprüche

1. Harzzusammensetzung für Stereolithographie, (i) umfassend:
eine Epoxyverbindung (A);
eine ethylenisch ungesättigte Verbindung (B);
einen Photoinitiator für kationische Polymerisation (C);
einen Photoinitiator für radikalische Polymerisation (D); und
eine Oxetanverbindung (E),
(ii) wobei eine Epoxyverbindung, die eine alicyclische Diglycidyletherverbindung enthält, als die Epoxyverbindung (A) in einem Anteil von 20 bis 100 Gew.-%, bezogen auf das Gesamtgewicht der Epoxyverbindung (A), beinhaltet ist, wobei die alicyclische Diglycidyletherverbindung durch die Formel (1) dargestellt ist: 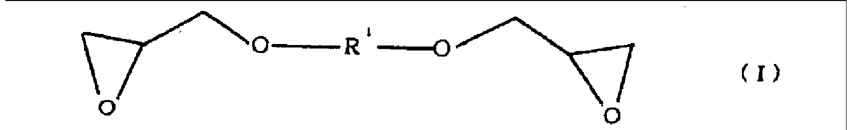 wobei R¹ einen hydrierten Bisphenol A -Rest, einen hydrierten Bisphenol F - Rest, einen hydrierten Bisphenol Z -Rest, einen Cyclohexandimethanolrest oder einen Tricyclodecandimethanolrest darstellt, und
(iii) wobei eine Oxetanverbindung, enthaltend eine Monooxetanverbindung (E1), die eine Oxetangruppe in einem Molekül davon besitzt; und eine Polyoxetanverbindung (E2), die zwei oder mehr Oxetangruppen in einem Molekül davon besitzt, als die Oxetanverbindung (E), in einem Gewichtsverhältnis der Monooxetanverbindung (E1) zu der Polyoxetanverbindung (E2) von 95:5 zu 5:95, beinhaltet ist,
wobei die Oxetanverbindung (E) in einem Anteil von 5 bis 60 Gew.-Teile, bezogen auf 100 Gew.-Teile der Epoxyverbindung (A), beinhaltet ist, und wobei die ethylenisch ungesättigte Verbindung (B) ausgewählt ist unter (Meth)Acrylestern von Alkoholen, Polyester(meth)acrylaten und Polyether(meth)acrylaten.

2. Harzzusammensetzung für Stereolithographie gemäß Anspruch 1, wobei die Polyoxetanverbindung (E2) eine Polyoxetanverbindung ist, die dargestellt ist durch die Formel (II): 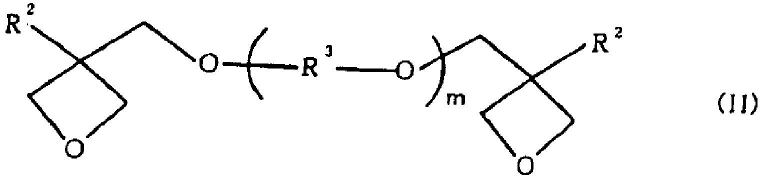 wobei die zwei R^{2,}s, die gleich oder verschieden sind, jeweils eine Alkylgruppe, die 1 bis 5 Kohlenstoffatome besitzt, darstellen; R³ eine bivalente organische Gruppe, die einen oder keinen aromatischen Ring besitzt, darstellt; und m 0 oder 1 darstellt.

3. Harzzusammensetzung für Stereolithographie gemäß Anspruch 1 oder 2, wobei die Monooxetanverbindung (E1) eine Monooxetanverbindung ist, die dargestellt ist durch die Formel (III): 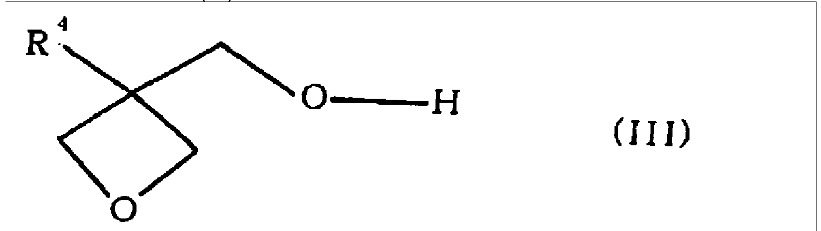 wobei R⁴ eine Alkylgruppe, die 1 bis 5 Kohlenstoffatome besitzt, darstellt.

## Revendications

1. Composition de résine pour stéréolithographie,
(i) comprenait
un composé époxy (A) ;
un composé à insaturation éthylénique (B) ;
un photoamorceur pour polymérisation cationique (C) ;
un photoamorceur pour polymérisation radicalaire (D) ; et un composé oxétane (E),
(ii) dans laquelle un composé époxy contenant un composé diglycidyléther alicyclique est incorporé en tant que composé époxy (A) en une proportion de 20 à 100 % en poids par rapport au poids total du composé époxy (A), le composé diglycidyléther alicyclique étant représenté par la formule (I) : 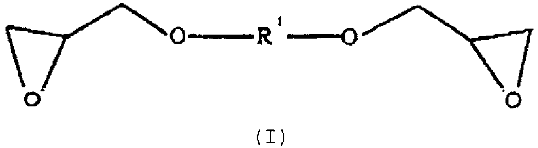 dans laquelle R¹ représente un résidu de bisphénol A hydrogéné, un résidu de bisphénol F hydrogéné, un résidu de bisphénol Z hydrogéné, un résidu de cyclohexane-diméthanol ou un résidu de tricyclodécanediméthanol, et
(iii) dans laquelle un composé oxétane contenant : un composé monooxétane (E1) ayant un seul groupe oxétane par molécule ; et un composé polyoxétane (E2) ayant deux ou plus de deux groupes oxétane par molécule, est incorporé en tant que composé oxétane (E) en un rapport en poids du composé monooxétane (E1) sur le composé polyoxétane (E2) de 95/5 à 5/95,
dans laquelle le composé oxétane (E) est incorporé en une proportion de 5 à 60 parties en poids pour 100 parties en poids du composé époxy (A), et dans laquelle le composé à insaturation éthylénique (B) est choisi parmi les esters (méth) acryliques d'alcools, les (méth) acrylates de polyester et les (méth) acrylates de polyéther.

2. Composition de résine pour stéréolithographie selon la revendication 1, dans laquelle le composé polyoxétane (E2) est un composé polyoxétane représenté par la formule (II) : 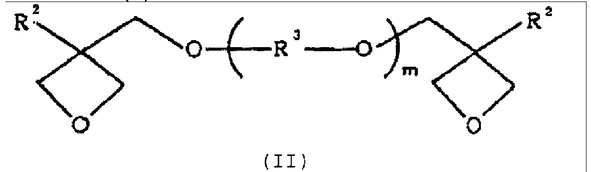 dans laquelle chacun des deux R², qui sont identiques ou différents, représente un groupe alkyle ayant de 1 à 5 atomes de carbone ; R³ représente un groupe organique divalent qui a ou n'a pas un cycle aromatique ; et m vaut 0 ou 1.

3. Composition de résine pour stéréolithographie selon la revendication 1 ou 2, dans laquelle le composé monooxétane (E1) est un composé monooxétane représenté par la formule (III) : 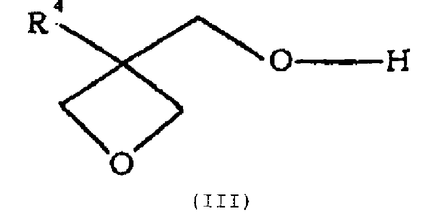 dans laquelle R⁴ représente un groupe alkyle ayant de 1 à 5 atomes de carbone.
